# EUROPEAN PATENT APPLICATION

(11) **EP 2 333 571 A1**
(43) Date of publication of application: **15.06.2011**
(21) Application number: 09816272.0
(22) Date of filing: 29.09.2009
(51) Int. Cl.: G01R 33/02, G07D 7/04

(54) **MAGNETIC SENSOR**

(30) Priority: 29.09.2008 JP 2008249389
(71) Applicant: Murata Manufacturing Co. Ltd., Kyoto 617-8555 (JP)
(72) Inventor: MINAMIDANI Tamotsu, Nagaokakyo-shi Kyoto 617-8555 (JP); NAKAMURA Munehisa, Nagaokakyo-shi Kyoto 617-8555 (JP); UEDA Masaya, Nagaokakyo-shi Kyoto 617-8555 (JP)
(74) Representative: Alder, Ettie-Ann
(86) International application number: PCT/JP2009/066899
(87) International publication number: WO 2010/035860

(57) **Abstract**

To obtain a magnetic sensor that includes the smallest possible cabinet, can be easily disposed, and can reliably and highly accurately detect the length or width of a magnetized portion forming a magnetic pattern, of an object to be detected.

A magnetic sensor (1') includes a cabinet (11') that is rectangular in a plan view, and multiple magnetic detection circuit elements (10) are arranged along the length direction of the cabinet (11'). The magnetic detection circuit elements (10) each has a structure where a magnetic resistance element (MR1) and a constant resistance element (R1) each having a long length are disposed in parallel with each other, and are disposed so that the length directions thereof are parallel with one another. The magnetic detection circuit elements (10) are disposed in the cabinet (11') so that the length direction of the cabinet (11') and the long-length direction of the magnetic detection circuit elements (10) form a predetermined angle θ other than 0° and 90°. The magnetic sensor (1') is disposed so that the long-length direction of the cabinet (11') is perpendicular to the carrying direction of the object (900) to be detected.

## Description

### Technical Field

The present invention relates to a magnetic sensor that detects magnetic information, such as a magnetic pattern, contained in an object to be detected.

### Background Art

Currently, various types of magnetic sensors are being devised that detect a magnetic pattern or magnetic information incorporated into a thin object to be detected, such as paper money.

For example, a magnetic sensor described in Patent Document 1 includes magnetic detection units that each include a magnetic resistance element having a long length and that are arranged in a rectangular cabinet along the direction of the long length of the cabinet. The magnetic resistance element of each magnetic detection unit is disposed so that the long-length direction of the magnetic resistance element is parallel with the length direction of the cabinet. In the case of the magnetic sensor described in Patent Document 1, a thin object to be detected is carried along a direction perpendicular to the length direction of the cabinet.

As the relationship between the length direction of a magnetic sensor and the carrying direction of an object to be detected, Patent Document 2 describes a configuration where one or more magnetic sensors each including a rectangular cabinet are disposed so that the length direction of the cabinet forms a predetermined angle other than 90° with the carrying direction of the object to be detected.
Patent Document 1: Japanese Unexamined Patent Application Publication No. 2005-251860
Patent Document 2: Japanese Unexamined Patent Application Publication No. 3-97084

### Problems to be Solved by the Invention

However, in the configuration where the length direction of the magnetic sensor is perpendicular to the carrying direction of the object to be detected, as shown in Patent Document 1, the magnetic resistance element having a long length is also perpendicular to the carrying direction of the object to be detected. For this reason, the carrying direction of the object to be detected and the direction of the short length of the magnetic resistance element (the width direction perpendicular to the long-length direction) become parallel with each other. This results in a reduction in the time duration during which the magnetic resistance element senses a variation in passing magnetic flux generated by a magnetized portion of a magnetic pattern, included in the thin object to be detected. Accordingly, if detection is simply intended to detect whether the magnetized portion is present, a large problem does not occur; if detection is intended to detect the length of the magnetized portion, it is difficult to detect the length with high accuracy. Particularly, if the length to be detected, of the magnetized portion of the object to be detected is parallel with the carrying direction and is short, it is more difficult to detect the length with high accuracy. Further, in such a structure, it is not possible to determine the length of the magnetized portion along a direction perpendicular to the carrying direction of the magnetized portion, that is, along the long-length direction of the magnetic resistance element.

On the other hand, in Patent Document 2, the multiple magnetic sensors are deposed at a predetermined angle with respect to the carrying direction of the object to be detected, that is, are disposed in a manner displaced from both the carrying direction of the object to be detected and a direction perpendicular to the carrying direction. Further, in Patent Document 2, signals obtained from the magnetic sensors are combined later to generate an output representing the magnetized portion.

As seen, if multiple magnetic sensors are used, the magnetic sensors must be disposed so that the length directions thereof are precisely parallel with one another. Further, the positions where the multiple magnetic sensors are disposed must be aligned precisely along the carrying direction of the object to be detected. Furthermore, since a voltage signal detected by the magnetic sensor largely depends on the gap (interval) between the magnetic resistance element and the object to be detected, the vertical positions of the multiple magnetic sensors must be aligned very precisely.

In view of such various problems, an object of the present invention is obtain a magnetic sensor that includes the smallest possible cabinet, can easily be disposed, and can detect with reliability and high accuracy the size of a magnetized portion forming a magnetic pattern, of an object to be detected.

### Means for Solving the Problems

A magnetic sensor according to the present invention includes: a cabinet whose length direction is a direction perpendicular to the carrying direction of an object to be detected and whose width direction is a direction parallel with the carrying direction; and a magnetic detection unit comprising a pair of a magnetic resistance element and a constant resistance element each having a long length, the resistance value of the magnetic resistance element varying due to passing magnetic flux, the resistance value of the constant resistance element substantially not varying due to the passing magnetic flux. The magnetic detection unit is disposed in the cabinet so that the long-length direction of the element pair is not parallel with or perpendicular to the length direction of the cabinet.

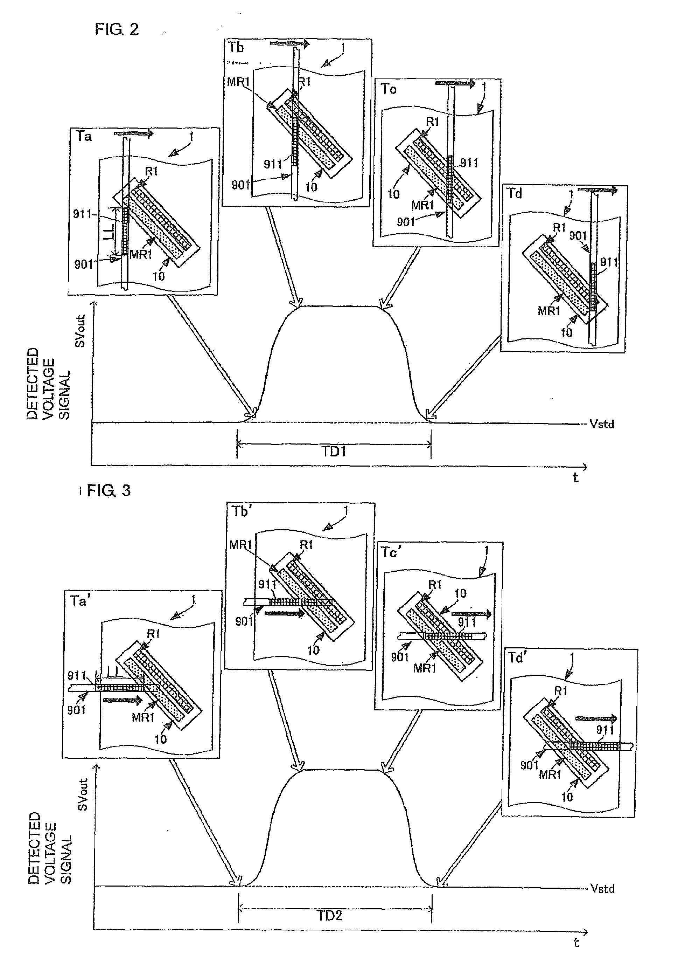

In this configuration, the short-length direction of the magnetic resistance element of the magnetic detection unit is not parallel with the carrying direction of the object to be detected including the magnetized portion, thereby increasing the time over which the magnetized portion is detected. Thus, the length to be measured, of the magnetized portion is reliably detected, whether the length is parallel with the carrying direction or perpendicular thereto, as shown in Fig. 2 or Fig. 3, For example, in the case where the length to be detected, of the magnetized portion is parallel with the carrying direction in this configuration, the time duration during which the magnetic resistance element senses passing magnetic flux generated by the magnetized portion and thus changes its resistance value is longer than that in the case where the short-length direction of the magnetic resistance element is parallel with the carrying direction.

The constant resistance element does not substantially change its resistance value due to the magnetized portion of the object to be detected, and only the magnetic resistance element changes its resistance value due to the magnetized portion of the object to be detected. Thus, a variation in level of the detected voltage signal precisely follows a variation in resistance value of the magnetic resistance element. Accordingly, when the magnetized portion of the magnetic resistance element passes by, an accurate detected voltage signal corresponding to the length to be detected, of the magnetized portion is obtained. Further, the size in the length direction, of the cabinet becomes smaller than that in the case where the long-length direction of the magnetic detection unit is made parallel with the length direction of the cabinet to dispose the cabinet at a predetermined angle relative to the carrying direction.

In the magnetic sensor according to the present invention, multiple magnetic detection units are disposed in the single cabinet. The multiple magnetic detection units are arranged in parallel with one another along the length direction of the cabinet, and the element pairs of the magnetic detection units are disposed so that the long-length directions thereof are identical to one another.

In this configuration, the multiple magnetic detection units that can detect the magnetized portions as described above are arranged. In this case, the arrangement direction is the length direction of the cabinet, that is, a direction perpendicular to the carrying direction of the object to be detected. Thus, the magnetized portions can be detected in multiple positions along the direction perpendicular to the carrying direction of the object to be detected. For example, if multiple magnetic detection units are arranged successively between both end portions along a direction perpendicular to the carrying direction, of the object to be detected, the magnetized portions can be detected regardless of in what positions in the direction perpendicular to the carrying direction of the object to be detected the magnetized persons lie. That is, whether the magnetized portions are arranged in the carrying direction or in the direction perpendicular to the carrying direction, it is possible to reliably detect the magnetized portions, as well as to detect the lengths to be detected, of the magnetised portions. Further, since the single cabinet contains the multiple magnetic detection units, the structure is simpler than a structure where a cabinet is provided for each magnetic detection unit, and the magnetic sensor is very precisely and easily disposed relative to the carrying path of the object to be detected.

Areas formed by projecting the element pairs of the multiple magnetic detection units of the magnetic sensor according to the present invention in the length direction of the cabinet lie successively along the length direction of the cabinet.

In this configuration, the areas detectable by any one of the multiple magnetic detection units lie successively along the direction perpendicular to the carrying direction of the object to be detected. Thus, the magnetized portions can be detected more reliably along the direction perpendicular to the carrying direction of the object to be detected.

In the magnetic sensor according to the present invention, the angle formed by the long-length direction of the element pair and the length direction of the cabinet is 45°.

Since, in this configuration, the angle formed by the carrying direction of the object to be detected and the magnetic resistance element is 45°, the detected voltage signal can be outputted over the same time duration, whether the length to be detected, of the magnetized portion is parallel with the carrying direction or perpendicular thereto. Thus, the magnetized portion can be detected equivalently, whether the length to be detected, of the magnetized portion is along the direction perpendicular to the carrying direction of the object to be detected or along the direction parallel therewith. Setting 46° results in a significant reduction in the possibility that the long-tength direction of the magnetic resistance element and the direction of the length to be detected, of the magnetized portion may become parallel with each other, even when the object to be detected is carried with an angle error. Thus, the length to be detected, of the magnetized portion is reliably detected.

### Advantages

According to the present invention, a magnetic sensor can be obtained that can detect the length to be detected, of the magnetized portion with reliability and high accuracy, whether the length to be detected, of the magnetized portion included in the object to be detected is parallel with the carrying direction of the object to be detected or perpendicular thereto. In this case, the cabinet of the magnetic sensor can be made as small as possible in accordance with the length in the direction perpendicular to the carrying direction, of the object to be detected. Further, it is easy to dispose multiple magnetic detection units very precisely relative to the carrying path of the object to be detected, as compared with a case where multiple magnetic detection units are disposed with themselves contained in individual cabinets relative to the carrying path of the object to be detected.

### Brief Description of Drawings

[Fig. 1] Figs 1 includes plan and side views of a magnetic sensor 1 according to a first embodiment and an equivalent circuit diagram of a magnetic detection unit of the magnetic sensor 1.
[Fig. 2] Fig. 2 is a drawing showing an operation for detecting a magnetized portion 901 performed by the magnetic sensor 1 having the configuration according to the first embodiment.
[Fig. 3] Fig. 3 is a drawing showing an operation for detecting the magnetized portion 901 performed by the magnetic sensor 1 having the configuration according to the first embodiment.
[Fig. 4] Fig. 4 includes drawings showing an advantageous effect obtained in the case where the magnetic sensor according to this embodiment generates a determination signal on the basis of a detected voltage signal SVout.
[Fig. 5] Fig. 5 includes drawings showing an advantageous effect obtained in the case where a conventional magnetic sensor that is compared with the magnetic sensor according to this embodiment generates a determination signal on the basis of a detected voltage signal SVout.
[Fig. 6] Fig. 6 is a schematic plan view showing the configuration of a magnetic sensor according to a second embodiment.
[Fig. 7] Fig. 7 is a drawing showing an operation for detecting multiple magnetized portions, 901A and 901B, performed by a magnetic sensor 1' having the configuration according to the second embodiment,

A magnetic sensor according to a first embodiment of the present invention will be described with reference to the drawings.

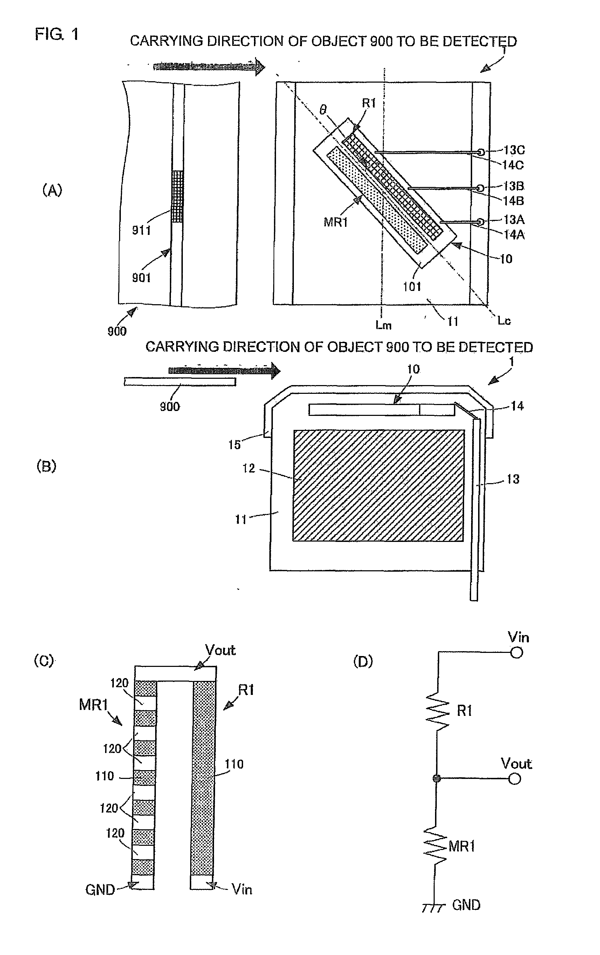

Fig. 1(A) is a plan view of a magnetic sensor 1 according to this embodiment. Fig. 1(B) is a side view of the magnetic sensor 1, Fig. 1(C) is a drawing showing a schematic configuration of a magnetic detection circuit element 10. and Fig. (D) is an equivalent circuit diagram of a magnetic detection unit of the magnetic sensor 1. Note that Fig. 1 (A) is a drawing showing the magnetic sensor 1 that is not covered with a cover 15.

The magnetic sensor 1 includes an approximately rectangular parallelepiped-shaped cabinet 11, which is composed of an insulating material. A permanent magnet 12 is disposed in the cabinet 11. The magnetic detection circuit element 10 is disposed in the vicinity of the side adjacent to an object 900 to be detected, of the permanent magnet 12. The cabinet 11 is formed in the shape of a rectangle or square having, as its length, a direction perpendicular to the carrying direction of the object 900 to be detected and having, as its width, a direction parallel with the carrying direction.

The magnetic detection circuit element 10 includes an insulating substrate 101, which is composed of Si or the like and is long and flat. A magnetic resistance element MR1, whose resistance value varies due to passing magnetic flux, and a constant resistance element R1, whose resistance value does not vary due to passing magnetic flux, are formed on the insulating substrate 101. For example, as shown in Fig, 1 (C), the magnetic resistance element MR1 is composed of a semiconductor film 110 formed of a semiconductor material, such as InSb, and having a long length, and is obtained by arranging short-circuit electrodes 120 formed of a conductive material on the semiconductor film 110 along the long length in a predetermined pattern. While the constant reliance element R1 is composed of a semiconductor film 110 formed of the same material as that of the magnetic resistance element MR1, no short-circuit electrodes 120 are formed on the semiconductor film 110. The constant resistance element R1 mary be formed of a different material unless its resistance value varies due to passing magnetic flux. The magnetic resistance element MR1 and the constant resistance element R1 are arranged so that the long-length directions thereof are parallel with each other, as well as are arranged along the short length-directions perpendicular to the long-length directions.

As shown in Fig. 1(C), respective end portions of the magnetic resistance element MR1 and the constant resistance element R1 formed of such material having such structures are connected to an output voltage electrode Vout composed of a conductive pattern. The other end portion of the magnetic resistance element MR1 is connected to a ground connection electrode composed of a conductive pattern, and that of the constant resistance element R1 to an input voltage electrode vin composed of a conductive pattern.

Further, an electrode pattern is formed on the insulating substrate 101 of the magnetic detection circuit element 10 so that a circuit as shown in Fig. 1(D) is formed That is, land electrodes for forming the input voltage electrode vin, the output voltage electrode vout, and the ground connection electrode GND are formed. Further, a wiring pattern electrode for connecting the constant resistance element R1 between the input voltage electrode vin and the ground connection electrode GND is formed, and a wiring pattern electrode for connecting the magnetic resistance element MR1 between the ground connection electrode GND and the output voltage electrode vout is formed.

Connection electrodes 14A to 14C connected to the land electrodes for forming the input voltage electrode Vin, the output voltage electrode Vout, and the ground connection electrode GND of the magnetic detection circuit element 10 are disposed in the cabinet 11 of the magnetic sensor 1. End portions of the connection electrodes 14A to 14C are connected to external connection conductors 13A to 13C, respectively, formed by conductor protruding from the bottom of the cabinet 11.

An insulating layer is present on the side adjacent to the carrying path of the object 900 to be detected, of the magnetic detection circuit element 10 in the cabinet 11, and the cover 15 is disposed own the cabinet 11 A surface of the cover 15 serves as the carrying path of the object 900 to be detected.

In such a configuration, the magnetic detection circuit element 10 is disposed so that the long-length direction thereof forms an angle other than 90° or 0° with the carrying direction of the object 900 to be detected. In other words, the magnetic detection circuit element 10 is disposed in the cabinet 11 so that an angle θ formed by an axis Lm along the length direction of the cabinet 11 perpendicular to the carrying direction of the object 900 to be detected and an axis Lc along the long-length direction of the magnetic detection circuit element 10 is a predetermined angle other than 0° and 90°. In this case, specifically, the angle θ formed by the axis Lm along the length direction of the cabinet 11 and the axis Lc along the long-length direction of the magnetic detection circuit element 10 is preferably 45°.

When the object 900 to be detected including a magnetized portion 901 is carried over the magnetic sensor 1 having such a configuration along the above-mentioned carrying path, a length LL to be detected, of the magnetized portion 901 is detected as shown below.

Figs. 2 and 3 are drawings showing an operation for detecting the magnetized portion 911 performed by the magnetic sensor 1 having the configuration according to this embodiment. Fig. 2 shows a case where the length LL to be detected is perpendicular to the carrying direction of the object 900 to be detected, and Fig. 3 shows a case where the length LL to be detected is parallel with the carrying direction of the object 900 to be detected. Note that Figs. 2 and 3 show cases where the angle θ formed by the axis Lm and the axis Lc is 45°. Also note that, in Figs. 2 and 3, the length LL is shown only at a timing Ta and is omitted at other timings, Tb, Tc, and Td.

As shown in Fig. 2, in the case where the length LL to be detected, of the magnetized portion 911 in a magnetic pattern 901 is perpendicular to the carrying direction (black, thick arrow in Fig. 2) of the object 900 to be detected, the length LL to be detected is detected through the following operation.

First, when one end portion in the direction of the length LL to be detected, of the magnetized portion 911 adjacent to the end portion upstream of the carrying direction, of the magnetic detection circuit element 10 having the long length comes over the magnetic resistance element MR1 of the magnetic detection circuit element 10, the value of a detected voltage signal SVout begins to rise from a reference voltage Vstd (timing Ta). As the object 900 to be detected continues to be carried, the value of the detected voltage signal SVout continues to rise. When the area where the magnetized portion 911 overlaps the magnetic resistance element MR1 is maximized during the carry, the value of the detected voltage signal SVout becomes constant (timing Tb). Although the magnetized portion 911 overlaps the constant resistance element R1 while such a change occurs, the resistance value of the constant resistance element R1 does not vary. Accordingly, the value of the detected voltage signal SVout is determined in accordance with the area where the magnetized portion 911 overlaps the magnetic resistance element MR1. While such overlaps continue, the value of the detected voltage signal SVout does not vary.

As the other end portion of the magnetized portion 911 opposed to the above-mentioned end portion thereof passes over the magnetic resistance element MR1, the value of the detected voltage signal SVout gradually falls to the reference voltage Vstd (timing Tc). When the magnetized portion 911 completely passes over the magnetic resistance element MR1, the value of the detected voltage signal SVout becomes the reference voltage Vstd (timing Td).

As seen, in the case where the length LL to be detected, of the magnetized portion 911 is perpendicular to the carrying direction, the value of the detected voltage signal SVout becomes a value different from the reference voltage Vstd when the magnetized portion 911 is linearly moving along the carrying direction while present over the magnetic resistance element MR1. Accordingly, detection of a time duration TD1 during which the value of the detected voltage signal SVout differs from the reference voltage Vstd allows determination of the length LL to be detected, of the magnetized portion 911. In a precise sense, the time duration TD1 corresponds to the distance between the opposed angles of the rectangular magnetized portion 911. Since the pattern width of the magnetized portion 911 (the width of the magnetic pattern 901 perpendicular to the length LL to be detected) is generally predetermined, the length LL may be determined taking this width into consideration Further, since the time duration during which the value of the detected voltage signal SVout rises or falls depends on the width of the magnetic pattern 901, the width may be detected using the rise time or fall time so as to determine the length LL.

On the other hand, in the case where the length LL to be detected, of the magnetized portion 911 is parallel with the carrying direction of the object 900 to be detected (black thick arrow in Fig. 3) as shown in Fig. 3, the length LL to be detected is detected through the following operation.

First, as one end portion downstream of the carrying direction, of the magnetized portion 911 comes over the magnetic resistance element MR1 of the magnetic detection circuit element 1, the value of the detected voltage signal SVout begins to rise from the reference voltage Vstd (timing Ta').

As the object 900 to be detected continues to be carried, the value of the detected voltage signal SVout continues to rise. When the area where the magnetized portion 911 overlaps the magnetic resistance element MR1 is maximized during the carry, the value of the detected voltage signal SVout becomes constant (timing Tb'). While such an overlap continues, the value of the detected voltage signal SVout does not vary.

As the other end portion upstream of the carrying direction, of the above-mentioned magnetized portion 911 passes over the magnetic resistance element MR1, the value of the detected voltage signal SVout gradually falls to the reference voltage Vstd (timing Tc'). When the magnetized portion 911 completely passes over the magnetic resistance element MR1, the value of the detected voltage signal SVout becomes the reference voltage Vstd (timing Td').

As seen, in the case where the length LL to be detected, of the magnetized portion 911 is parallel with the carrying direction, the value of the detected voltage signal SVout becomes a value different from the reference voltage Vstd when the magnetized portion 911 is linearly moving along the carrying direction while present over the magnetic resistance element MR1. Accordingly, detection of a time duration TD2 during which the value of the detected voltage signal SVout differs from the reference voltage Vstd allows determination of the length LL to be detected, of the magnetized portion 911. In a precise sense, the time duration TD2 also corresponds to the distance between the opposed angles of the rectangular magnetized portion 911. Since the pattern width of the magnetized portion 911 (the width of the magnetic pattern 901 perpendicular to the length LL to be detected) is generally predetermined, the length LL may be determined taking this width into consideration. Further, since the time duration during which the value of the detected voltage signal SVout rises or falls depends on the width of the magnetic pattern 901, the width may be detected using the rise time or fall time so as to determine the length LL.

As seen, use of the configuration according to this embodiment allows reliable detection of the presence or absence of the magnetized portion 911, whether the length LL, to be detected, of the magnetized portion 911 is parallel with the carrying direction of the object 900 to be detected or perpendicular thereto. In any case, a time having a certain length or longer can be taken as the time duration for detecting the length LL. For this reason, the length LL can be detected wit high accuracy.

In this case, since 45° is set as the formed angle θ described above, the time durations TD1 and TD2 described above are made equal to each other. Thus, the length LL can be determined using a single measurement time duration, whether the direction of the length LL to be detected, of the magnetized portion 911 is parallel with the carrying direction or perpendicular thereto. While the formed angle θ is preferably 45°, there may be an error of the order of ±5° to ±10°. In this case, there is a difference in time duration between the case where the direction of the length LL to be detected, of the magnetized portion 911 is parallel with the carrying direction and the case where it is perpendicular to the carrying direction. However, the direction of the length LL does not match the long-length direction of the magnetic resistance element MR1, allowing reliable detection of the length LL.

Meanwhile, in determining the length LL of the magnetized portion 911 using the detected voltage signal SVout as described above, a determination signal may be generated on the basis of the detected voltage signal SVout and used to determine the length LL. Examples of such a determination signal include a signal obtained by differentiating and amplifying the detected voltage signal SVout. Use of this determination signal allows an additional advantage shown below to be obtained.

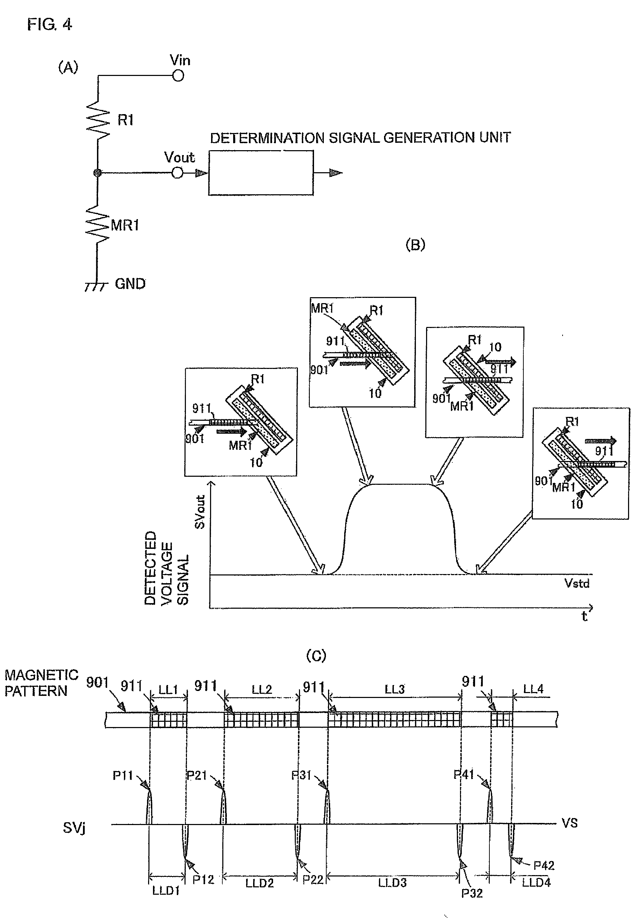

Fig. 4 includes drawings showing an advantageous effect obtained in the case where the magnetic sensor according to this embodiment generates a determination signal on the basis of the detected voltage signal SVout. Fig. 4(A) is an equivalent circuit diagram of a circuit configuration where the determination signal is generated. Fig. 4(B) is a drawing showing an operation for detecting the detected voltage signal SVout, and Fig. 4(C) is a drawing showing the temporal relationship between the detection of the magnetized object and the determination signal.

A circuit shown in Fig. 4(A) is obtained by connecting a determination signal generation unit to the output voltage electrode Vout in the circuit of the magnetic sensor 1 shown in Fig. 1(D). Accordingly, the detected voltage signal SVout has voltage characteristics similar to those described with reference to Fig. 3.

The determination signal generation unit outputs a determination signal Svj by differentiating the detected voltage signal SVout and amplifying the resultant signal by a predetermined amplification factor. The determination signal Svj is a dffferential signal of the detected voltage signal SVout. Thus, in the period during which, after the magnetized portion 911 comes over the magnetic resistance element MR1, the area where the magnetized portion 911 lies over the magnetic resistance element MR1 gradually increases so that the detected voltage signal SVout rises from the reference potential Vstd and so that the rate of voltage rise increases, the determination signal Svj exhibits a characteristic where it rises to reach a predetermined maximum value (for example, P11, P21, P31, or P41 shown in Fig. 4(C)). In the period during which the rate of voltage rise of the detected voltage signal SVout decreases, the determination signal Svj falls from the maximum value to a reference potential VS. When the area where the magnetized portion 911 lies over the magnetic resistance element MR1 becomes constant, the detected voltage signal SVout becomes constant so that the determination signal Svj becomes constant at the reference potential VS. While the magnetized object 911 also comes over the constant resistance element R1 in this case, the resistance value of the constant resistance element R1 does not vary substantially. Thus, the constant resistance element R1 does not contribute to a variation in voltage of the determination signal Svj. Accordingly, if the configuration according to this embodiment is used, a characteristic is exhibited where one maximum value is obtained when the top end of the magnetized object 911 is detected.

On the other hand, in the period during which, after the tail end of the magnetized object 911 comes over the magnetic resistance element MR1, the area where the magnetized object 911 lies over the magnetic resistance element MR1 gradually decreases so that the detected voltage signal SVout falls toward the reference potential Vstd and during which the rate of voltage decrease rises, the determination signal Svj exhibits a characteristic where it falls from the reference potential VS to reach a predetermined minimum value (for example, P12, P22, P32, or P42 shown in Fig. 4(C)).

In the period during which the rate of voltage decrease of the detected voltage signal SVout falls, the determination signal Svj rises from the minimum value toward the reference potential VS. When the magnetized object 911 passes over the magnetic resistance element MR1, the detected voltage SVout becomes constant so that the determination signal Svj becomes constant at the reference potential VS. While the magnetized object 911 also comes over the constant resistance element R1 in this case, the resistance value of the constant resistance element R1 does not vary substantially. Thus, the constant resistance element R1 does not contribute to a variation in voltage of the determination signal Svj. Accordingly, if the configuration according to this embodiment is used, a characteristic is exhibited where one minimum value is obtained when the tail end of the magnetized object 911 is detected.

Such characteristics are exhibited. Thus, in determining the length of the magnetized object 911, it is sufficient to detect a pair of temporally successive maximum and minimum values with respect to the single magnetized object. In practice, an absolute value process may be performed using the reference value VS as a reference "0" potential so as to detect a pair of maximum values (a maximum value and a maximum value obtained by determining a minimum value relative to the reference value VS). In any case, the length of the magnetized object 911 can be detected on the basis of the maximum value (minimum value) that singly exists in each of the top end and tail end of the magnetized object. For example, in Fig. 4(C), a length LLD1 can be detected by detecting the maximum value P11 and the maximum value P12 with respect to the magnetized object having a length LL1 and obtaining the difference between the detection times. A length LLD2 can be detected by detecting the maximum value P21 and the maximum value P22 with respect to the magnetized object having a length LL2 and obtaining the difference between the detection times. A length LLD3 can be detected by detecting the maximum value P31 and the maximum value P32 with respect to the magnetized object having a length LL3 and obtaining the difference between the detection times. A length LLD4 can be detected by detecting the maximum value P41 and the maximum value P42 with respect to the magnetized object having a length LL4 and obtaining the difference between the detection times.

As seen, use of the configuration according to this embodiment allows highly accurate detection of the length of the magnetized object 911.

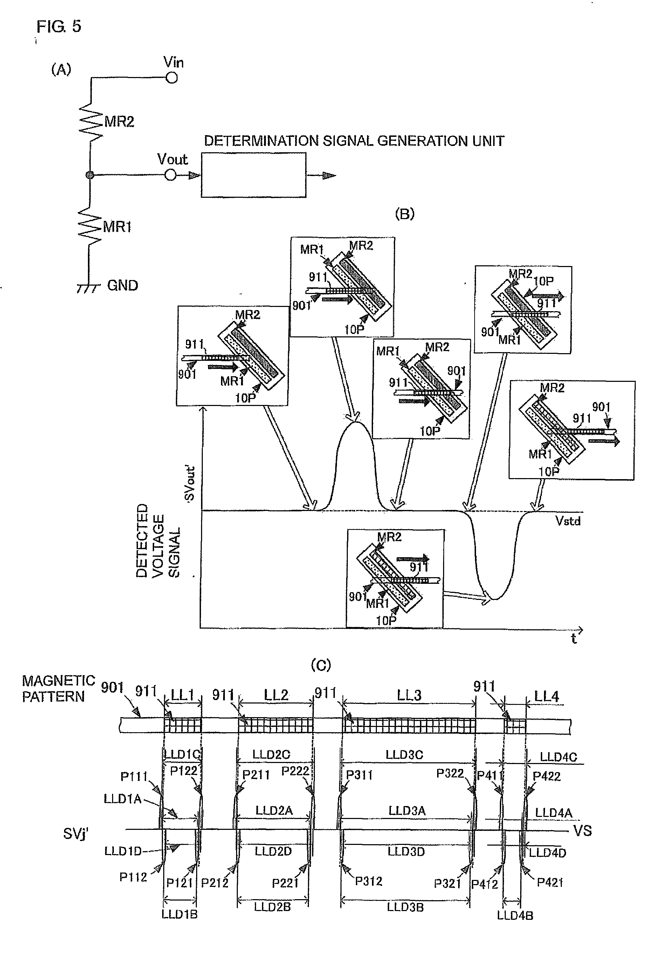

Next, in comparison with the configuration according to this embodiment, the determination accuracy of the magnetized object in the case where a conventional configuration as shown in Fig. 5 is employed will be described. The conventional configuration described here is a configuration where two magnetic resistance elements, MR1 and MR2, are disposed in a manner parallel with each other, that is, a configuration obtained by replacing the constant resistance element R1 included in the configuration according to this embodiment with the magnetic resistance element MR2.

Fig. 5 includes drawings showing an advantageous effect obtained in the case where a conventional magnetic sensor that is compared with the magnetic sensor according to this embodiment generates a determination signal on the basis of the detected voltage signal SVout. Fig. 5(A) is an equivalent circuit diagram of a circuit configuration where the determination signal is generated, Fig. 5(B) is a drawing showing an operation for detecting the detected voltage signal SVout, and Fig. 5(C) is a drawing showing the temporal relationship between the detection of the magnetized object and the determination signal.

A circuit shown in Fig. 5(A) is obtained by replacing the constant resistance element R1 of a magnetic detection circuit element 10P according to this embodiment shown in Fig. 4(A) with the magnetic resistance element MR2.

In such a configuration, a detected voltage signal SVout' exhibits the following characteristics. First, the characteristics exhibited from the time when the magnetized object 911 comes over the magnetic resistance element MR1 to the time when the area where the magnetized object 911 lies over the magnetic resistance element MR1 is maximized so that the maximum value is obtained are the same as those shown in Fig. 4(A).

Next, as the area where the magnetized object 911 lies over the magnetic resistance element MR2 increases after the top end of the magnetized object 911 comes over the magnetic resistance element MR2 with the magnetized object 911 lying over the magnetic resistance element MR1, the resistance value of the magnetic resistance element MR2 rises. Accordingly, the detected voltage signal SVout' falls. Subsequently, when the area where the magnetized object 911 lies over the magnetic resistance element MR1 and the area where the magnetized object 911 lies over the magnetic resistance element MR2 are equalized, the detected voltage signal SVout' returns to the reference potential Vstd.

In the period during which the area where the magnetized object 911 lies over the magnetic resistance element MR1 and the area where the magnetized object 911 lies over the magnetic resistance element MR2 are equalized, the detected voltage signal SVout' is constant at the reference potential Vstd.

Next, when the tail end of the magnetized object 911 comes over the magnetic resistance element MR1 so that the area where the magnetized object 911 lies over the magnetic resistance element MR1 decreases, the resistance value of the magnetic resistance element MR1 falls. Accordingly, the detected voltage signal SVout' falls from the reference potential Vstd. When the magnetized object 911 passes over the magnetic resistance element MR1 and lies over only the magnetic resistance element MR2, the value of the detected voltage signal SVout' is minimized. Subsequently, when the tail end of the magnetized object 911 comes over the magnetic resistance element MR2 so that the area where the magnetized object 911 lies over the magnetic resistance elements MR2 decreases, the detected voltage signal SVout' returns to the reference potential Vstd.

In such a case, a determination signal Svj' exhibits the following characteristics,

First, in the period from the time when the magnetized object 911 comes over the magnetic resistance element MR1 to the time when the area where the magnetized object 911 is present the magnetic resistance element MR1 is maximized, the determination signal Svj' exhibits a characteristic where it temporarily rises to reach a predetermined maximum value (for example, P111, P211, P311, or P411 shown in Fig. 5(C)) and then returns to the reference potential VS. Subsequently, in the period from the time when the magnetized object 911 also comes over the magnetic resistance element MR2 to the time when the area where the magnetized object 911 lies over the magnetic resistance element MR2 is maximized, the determination signal Svj' exhibits a characteristic where it temporarily falls to reach a predetermined minimum value (for example, P1I2, P212, P312, or P412 shown in Fig. 5(C)) and then rises to return to the reference potential VS.

On the other hand, in the period from the time when the area where the magnetized object 911 lies over the magnetic resistance element MR1 decreases to the time when the magnetized object 911 passes over the magnetic resistance element MR1, the determination signal Svj' exhibits a characteristic where it temporarily falls to reach a predetermined minimum value (for example, P12I, P221, P321, or P421 shown in Fig. 5(C)) and then rises to return to the reference value VS. Subsequently, in the period from the time when the area where the magnetized object 911 lies over the magnetic resistance element MR2 decreases to the time when the magnetized object 911 passes over the magnetic resistance element MR2, the determination signal Svj' exhibits a characteristic where it temporarily rises to reach a predetermined maximum value (for example, P122, P222, P322, or P422 shown in Fig. 5(C)) and then falls to return to the reference potential VS.

Such characteristics are exhibited. Thus, in determining the length of the magnetized object 911, a pair of extremely temporally close, successive maximum and minimum values are present with respect to the top end of the single magnetized object (for example, P111 and P112 shown in Fig. 5(C)) and, similarly, a pair of extremely temporally close, successive maximum and minimum values are present with respect to the tail end of the single magnetized object (for example, P121 and P122 shown in Fig. 5(C)).

If it is desired to calculate the length of the magnetized object 911 with high accuracy, it is necessary to combine the maximum value at the top end of the magnetized object 911 and the minimum value at the tail end thereof or combine the minimum value at the top end and the maximum value at the tail end.

Specifically, in the case of the magnetized object having the length LL1 shown in Fig. 5(C), it is necessary to combine the P111 at the top end of the magnetized object and P121 at the tail end thereof so as to calculate a length LLD1A or combine P112 at the top end of the magnetized object and P122 at the tail end thereof so as to calculate a length LLD1D.

However, the maximum value P111 and the minimum value P112 at the top end are temporally close to each other, making it difficult to intentionally detect any one of these values. Similarly, the minimum value P121 and the maximum value P122 at the tail end are temporally close to each other, making it difficult to intentionally detect any one of these values, For this reason, reliably selecting a proper pair of maximum value and minimum values is substantially an extremely difficult process. In particular, when the above-mentioned absolute value process is performed, the maximum values becomes temporally close to each other, raising a possibility that erroneous detection may occur.

Thus, in the conventional configuration, an error occurs in each of the timing when detection is performed at the top end of the magnetized object and the timing when detection is performed at the tail end thereof and therefore the length of the magnetized object cannot be detected with reliability and high accuracy, unlike in the configuration according to this embodiment.

As described above, use of the configuration according to this embodiment allows removal of a detection error factor that cannot be removed by the conventional configuration, allowing highly accurate detection of the length of the magnetized object 911.

Next, a magnetic sensor according to a second embodiment will be described with reference to the drawings.

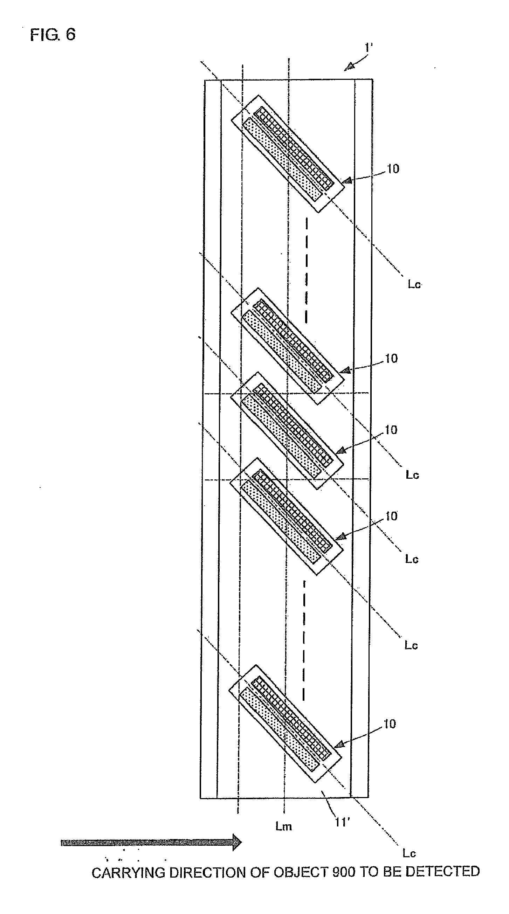

Fig. 6 is a schematic plan view showing the configuration of the magnetic sensor according to the second embodiment.

As shown in Fig. 6, in a magnetic sensor 1' according to this embodiment, multiple magnetic detection circuit elements 10 are arranged in a cabinet 11', which is rectangular in a plan view. Although not shown, a permanent magnet, connection conductors, and external connection conductors are disposed in the cabinet 11' as shown in the first embodiment, and the side adjacent to the carrying path, of the cabinet 11' is covered by a cover. The cabinet 11' is formed so that it has a length approximately along the direction perpendicular to the carrying direction of an object 900 to be detected.

The multiple magnetic detection circuit elements 10 each have the same configuration as that shown in the first embodiment and are disposed along the length direction of the cabinet 11'. In this case, the magnetic detection circuit elements 10 are disposed so that the magnetic resistance elements MR1 thereof are located upstream of the carrying direction.

Further, the magnetic detection circuit elements 10 are disposed so that all axes Lc along the long-length directions thereof form the same angle with the axis Lm along the length direction of the cabinet 11'.

Further, the magnetic detection circuit elements 10 are disposed so that the corners upstream of the carrying direction, of the magnetic resistance elements MR1 formed therein are located in the same positions in the carrying direction. Further, the magnetic detection circuit elements 10 are disposed so that projection areas formed by projecting the disposition areas of the magnetic resistance elements MR1 thereof in the length direction of the cabinet 11' lie successively.

Use of such a structure allows detection of the magnetized portion 911 of the object 900 to be detected, regardless of in which position in the direction perpendicular to the carrying direction the magnetized portion 911 is located. Further even if the magnetic pattern 901 is formed along the direction perpendicular to the carrying direction and if multiple magnetized portions 911 lie along the perpendicular direction, the multiple magnetized portions 911 can be detected individually.

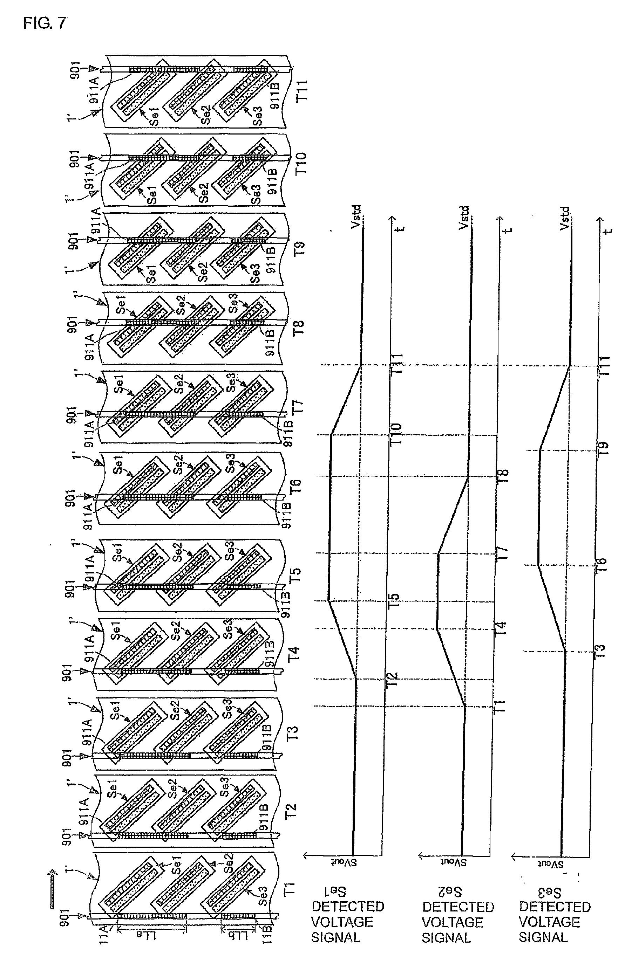

Fig. 7 is a drawing showing an operation for detecting multiple magnetized portions 911A and 911B performed by the magnetic sensor 1' having the configuration according to this embodiment and shows a case where lengths LLa and LLb to be detected are perpendicular to the carrying direction of the object 900 to be detected. Note that Fig. 7 shows a case where an angle θ formed by an axis Lm along the length direction of the cabinet 11' and an axis Lc along the long-length direction of each magnetic detection circuit element 10 is 45°. In Fig. 7, the magnetic detection circuit elements 10 are denoted as Se1, Se2, and Se3 so that they are identified in the explanation. Fig. 7 also shows a case where the magnetized portion 911A having the length LLa to be detected, which is longer than a length obtained when projecting the magnetic detection circuit element 10 in the long-length direction of the cabinet 11', and the magnetized portion 911B having the length LLb to be detected, which is shorter than a length obtained by projecting the magnetic detection circuit element 10 in the long-length direction of the cabinet 11', are arranged. In Fig. 7, the numerals are given only for a timing T1 and omitted for other timings.

In the case of the arrangement pattern including the magnetized portions 911A and 911 B shown in Fig. 7, first, the intermediate portion in the direction of the length LL1a, of the magnetized portion 911A comes over the magnetic detection circuit element Se2, raising the value of the detected voltage signal SVout of the magnetic detection circuit element Se2 (timing T1).

Next, one end portion in the direction of the length LLa, of the magnetized portion 911A comes over the magnetic detection circuit element Se1, raising the value of the detected voltage signal SVout of the magnetic detection circuit element Se1 (timing T2).

Next. one end portion in the direction of the length LLb, of the magnetized portion 911B comes over the magnetic detection circuit element Se3, raising the value of the detected voltage signal SVout of the magnetic detection circuit element Se3 (timing T3).

The object 900 to be detected continues to be carried. When the area where the magnetized portion 911A overlaps the magnetic detection circuit element Se2 is maximized during the carry, the value of the detected voltage signal SVout of the magnetic detection circuit element Se2 is maximized and fixed to the maximum value (timing T4). Similarly, when the area where the magnetized portion 911A overlaps the magnetic detection circuit element Se1 is maximized while the object 900 to be detected is carried, the value of the detected voltage signal SVout of the magnetic detection circuit element Se1 is maximized and fixed to the maximum value (timing T5). When the area where the magnetized portion 911B overlaps the magnetic detection circuit element Se3 is maximized while the object 900 to be detected is carried, the value of the detected voltage signal SVout of the magnetic detection circuit element Se3 is maximized and fixed to the maximum value (timing T6). While such overlaps continue, the value of the detected voltage signal SVout does not vary.

As the above-mentioned magnetized portion 911A passes over the magnetic detection circuit element Se2, the value of the detected voltage signal SVout of the magnetic detection circuit element Se2 gradually falls to the reference voltage Vstd (from timing T7 to timing T8). Similarly, as the magnetized portion 911A passes over the magnetic detection circuit element Se1, the value of the detected voltage signal SVout of the magnetic detection circuit element Se1 gradually falls to the reference voltage Vstd (from timing T10 to timing T11). As the magnetized portion 911B passes over the magnetic detection circuit element Se3, the value of the detected voltage signal SVout of the magnetic detection circuit element Se3 gradually falls to the reference voltage Vstd (from timing T9 to timing T11).

As seen, even if the multiple magnetized portions 911 (911A and 911B) are arranged along the direction perpendicular to the carrying direction of the object 900 to be detected, the magnetized portions 911 can be detected individually. In this case, if the length LL to be detected, of the magnetized portions 911 is longer than a length obtained by projecting the magnetic detection circuit elements 10 (Se) in the length direction of the cabinet 11', the length LL can be detected using the same method as that in the above-mentioned first embodiment.

Further, in this embodiment, even if the length LL to be detected, of the magnetized portions 911 is longer than a length obtained by projecting of the magnetic detection circuit elements 10 (Se) in the length direction of the cabinet 11' or if a magnetized portion 911 extends over multiple magnetic detection circuit elements 10 (Se), the length LL can be detected.

This detection can be achieved, for example, by summing up the time duration during which the above-mentioned magnetized portion 911A is detected by the magnetic detection circuit element Se1 and the time duration during which the magnetized unit 911A is detected by the magnetic detection circuit element Se2. This will be explained below using the magnetized portion 911A shown in Fig. 7 as an example.

As shown in Fig. 7, the magnetic detection circuit elements Se1 and Se2 are arranged successively along the direction of the length LLa to be detected, of the magnetized portion 911A. Accordingly, it is conceivable that the magnetized portion 911A be equivalent to a shape where a portion passing over the magnetic detection circuit element Se1 and a portion passing over the magnetic detection circuit element Se2 are connected along the direction of the length LLa. Using this idea the length of the magnetized portion 911A is divided into a length to be measured by the magnetic detection circuit element Se1 and a length to be measured by the magnetic detection circuit element Se2, which are then summed up to determine the entire length LLa of the magnetized portion 911A. The partial length of the magnetized portion 911A to be measured by the magnetic detection circuit element Se1 corresponds to the period during which the magnetic detection circuit element Se1 is observing the detected voltage signal SVout having a level different from that of the reference voltage Vstd due to the passage of the magnetized portion 911A. Thus, as shown in Fig. 7, the partial length to be measured by the magnetized object 911A can be calculated from the time difference between the timing T11 and the timing T2. Similarly, the partial length of the magnetized portion 911A to be measured by the magnetic detection circuit element Se2 corresponds to the period during which the magnetic detection circuit element Se2 is observing the detected voltage signal SVout having a level different from that of the reference voltage Vstd due to the passage of the magnetized portion 911A and can be calculated from the time difference between the timing T8 and the timing T1. Summing up of the length obtained from the time difference between the timing T11 and the timing T2 and the length obtained from the time difference between the timing T8 and the timing T1 allows detection of the entire length LLa of the magnetized portion 911A.

As seen, use of the configuration according to this configuration allows reliable and highly accurate detection of the length LL to be detected, of the magnetized portion 911, regardless of in what position in the direction perpendicular to the carrying direction of the object 900 to be detected the magnetized portion 911 is located. Further, even if multiple magnetized portions are arranged in the direction perpendicular to the carrying direction of the object 900 to be detected, it is possible to detect the length to be detected, of each magnetized portion 911 with reliability and high accuracy, as well as to detect the arrangement pattern of the magnetized portions.

In the configuration according to this embodiment, if the length to be detected, of the magnetized portion is parallel with the carrying direction, the length to be detected, of the magnetized portion can reliably be detected, as in the first embodiment.

Further, even if multiple such magnetized portions are arranged along the carrying direction, the magnetized portions are detected independently chronologically. Thus, it is possible to detect the multiple magnetized portions with reliability and high accuracy, as well as to detect the pattern of the magnetized portions.

Use of the configuration according to this embodiment allows obtaining of a magnetic sensor that has the above-mentioned advantage in detecting the magnetized portion as long as the cabinet 11' has at least a length along the direction perpendicular to the carrying direction of the object 900 to be detected. That is, it is possible to form the smallest possible magnetic sensor in accordance with the shape of the object 900 to be detected. Further, since the multiple magnetic detection circuit elements 10 are arranged in the single cabinet 11', simply disposing the cabinet 11' so that the surface adjacent to the object 900 to be detected, of the cabinet 11' is parallel with the carrying path of the object 900 to be detected allows equalization of the respective distances between the multiple magnetic detection circuit elements 10 and the carrying path of the object 900 to be detected. In the meantime, magnetic sensors, including that according to the present invention, have a severe gap characteristic where even existence of a gap of the order of 0.1 mm between the object 900 to be detected and the cabinet 11' reduces the output characteristics by 30%. Use of the configuration according to the above-mentioned embodiment allows the cabinet 11' to be precisely disposed so that the respective distances between the object 900 to be detected and the multiple magnetic detection circuit elements 10 are less than 0.1 mm, allowing easy disposition of a high-accuracy magnetic sensor having a wide detection area.
- 1,1': magnetic sensor
- 10, 10P: magnetic detection circuit element
- 11, 11': cabinet
- 12: permanent magnet
- 13, 13A to 13C: external connection conductor
- 14, 14A to 14C: connection conductor
- 15: cover
- 101: insulating substrate
- 900: object to be detected
- 901: magnetized portion
- MR1, MR2: magnetic resistance element
- R1: constant resistance element

## Claims

1. A magnetic sensor comprising:
a cabinet whose length direction is the direction perpendicular to the carrying direction of an object to be detected and whose width direction is a direction parallel with the carrying direction; and
a magnetic detection unit comprising a pair of a magnetic resistance element and a constant resistance element each having a long length, the resistance value of the magnetic resistance element varying due to passing magnetic flux, the resistance value of the constant resistance element substantially not varying due to the passing magnetic flux, wherein
the magnetic detection unit is disposed in the cabinet so that the long-length direction of the element pair is not parallel with or perpendicular to the length direction of the cabinet.

2. The magnetic sensor according to Claim 1, wherein the magnetic detection unit comprises a plurality of magnetic detection units, and
the magnetic detection units are arranged in parallel with one another along the length direction of the cabinet, and the element pairs of the magnetic detection units are disposed so that the long-length directions thereof are identical to one another.

3. The magnetic sensor according to Claim 2, wherein
areas formed by projecting the element pairs of the magnetic detection units in the length direction of the cabinet lie successively along the length direction of the cabinet.

4. The magnetic sensor according to any one of Claims 1 to 3, wherein
the angle formed by the long-length direction of the element pair and the length direction of the cabinet is 45°.
